Europäisches Patentamt

European Patent Office

Office européen des brevets

(19)

(11) Veröffentlichungsnummer: **0 010 221**
**B1**

(12) **EUROPÄISCHE PATENTSCHRIFT**

(45) Veröffentlichungstag der Patentschrift:
09.02.83

(21) Anmeldenummer: 79103755.9

(22) Anmeldetag: 02.10.79

(51) Int. Cl.³: **G 01 R 15/07**, G 01 D 5/28

(54) **Faseroptisches Messgerät.**

(30) Priorität: 12.10.78 SE 7810643

(43) Veröffentlichungstag der Anmeldung:
30.04.80 Patentblatt 80/9

(45) Bekanntmachung des Hinweises auf die Patenterteilung:
09.02.83 Patentblatt 83/6

(84) Benannte Vertragsstaaten:
CH DE FR GB IT

(56) Entgegenhaltungen:
DE-A-2 345 498
DE-A-2 549 497
DE-A-2 849 186
DE-B-1 915 478
DE-B-1 930 111

(73) Patentinhaber: ASEA AB, S-721 83 Västeras (SE)

(72) Erfinder: Adolfsson, Morgan, Dipl.-Ing., Sigfrid Edströms gata 86, S-724 66 Västeras (SE)
Erfinder: Brogardh, Torgny, Platverksgatan 140, S-724 74 Västeras (SE)

(74) Vertreter: Boecker, Joachim, Dr.-Ing., Rathenauplatz 2-8, D-6000 Frankfurt a.M. 1 (DE)

## Faseroptisches Meßgerät

Die Erfindung betrifft ein faseroptisches Meßgerät zur Strom- und/oder Spannungsmessung gemäß dem Oberbegriff des Anspruches 1. Ein solches Meßgerät ist bekannt aus der DE-AS 1 930 111.

Bei der Messung von Strömen und Spannungen werden normalerweise entweder elektromechanische oder ganz oder teilweise elektronische Geräte verwendet, die mit Transformatoren, Shunten oder Spannungsteilern elektrisch verbunden sind. Ein großes Problem bei derartigen Meßsystemen besteht darin, den Einfluß von Störungen zu beseitigen, die beispielsweise auf den Übertragungsleitungen in die Meßsignale gelangen. Diese Störungen müssen unterdrückt werden, damit sie nicht die Anzeige des Meßsignals verfälschen. Ein weiteres Problem ist die Unterdrückung von gleichphasigen Störspannungen (»common-mode«-Unterdrückung). Weitere Probleme treten beim Messen auf hohem Potential auf, wo die Gefahr elektrischer Überschläge besteht oder die Anzeige hochspannungsfrei sein soll, und wenn Meßsysteme eigensicher gemacht werden sollen.

Das aus der DE-AS 1 930 111 bekannte Meßgerät dient in erster Linie der Messung der Bewegung von gegeneinander bewegten Teilen. Dabei kann die Bewegung eines dieser Teile auch in Abhängigkeit einer elektrischen Größe erfolgen. Bei dem bekannten Gerät wird das von der Lichtquelle kommende Licht an der Meßstelle einem Meßkopf zugeführt, auf dem auf der einen Seite Lichtaustritts- und auf der anderen Seite Lichteintrittsfasern angeordnet sind. Dieser Meßkopf wird dem bewegten Objekt gegenüber aufgebaut, auf welchem ein Spiegel von geeigneter Form derart angebracht wird, daß je nach Lage des bewegten Objektes mehr oder weniger Licht in die Lichtfaser zurückreflektiert wird. Diese bekannte Anordnung hat den Nachteil, daß das Meßergebnis durch Veränderungen der nach der Eichung eintretenden Intensität der Lichtquelle oder der Dämpfung der Fasern verfälscht wird. Außerdem ist dieses Meßgerät kaum geeignet, unter ungünstigen Umgebungsbedingungen eingesetzt zu werden.

Der Erfindung liegt die Aufgabe zugrunde, ein faseroptisches Meßgerät der eingangs genannten Art zu entwickeln, welches von den obengenannten Nachteilen bekannter Meßgeräte frei ist.

Zur Lösung dieser Aufgabe wird ein faseroptisches Meßgerät nach dem Oberbegriff des Anspruches 1 vorgeschlagen, welches erfindungsgemäß die im kennzeichnenden Teil des Anspruches 1 genannten Merkmale hat.

Vorteilhafte Weiterbildungen der Erfindung sind in den Unteransprüchen genannt.

Die Meßgeräte nach der Erfindung sind betriebssicher und gleichzeitig billig. Man kann bei den Messungen eine große Genauigkeit erzielen und auf einfache Weise die Anzeige von Instabilitäten und Alterungserscheinungen in beispielsweise Lichtleitern, Foto- und Leuchtdioden unabhängig machen. Man kann das erfassende Organ und den Geber mit sehr kleinen Abmessungen ausführen, und das Gerät kann u. a. für Debitierungs- und Relaisschutz-Zwecke benutzt werden.

Anhand der in den Figuren gezeigten Ausführungsbeispiele soll die Erfindung näher erläutert werden. Es zeigt

Fig. 1 einen temperaturkompensierten bimorphen Modulator, wobei Licht mit zwei verschiedenen Wellenlängen benutzt wird,

Fig. 2 ein faseroptisches Meßgerät mit zwei piezoelektrischen Stapeln,

Fig. 3 ein faseroptisches Meßgerät mit piezoelektrischen Polymeren,

Fig. 4 einen Geber, bei dem die Modulation durch die magnetischen Kräfte zwischen einer stromdurchflossenen Spule und einem Weicheisenstück bewirkt wird,

Fig. 5 einen Geber, bei dem die Modulation durch die Längendehnung eines stromdurchflossenen Leiters bewirkt wird,

Fig. 6 einen Geber, bei dem die Modulation durch die Formänderung zweier vom Meßstrom erhitzter Bimetallstücke bewirkt wird.

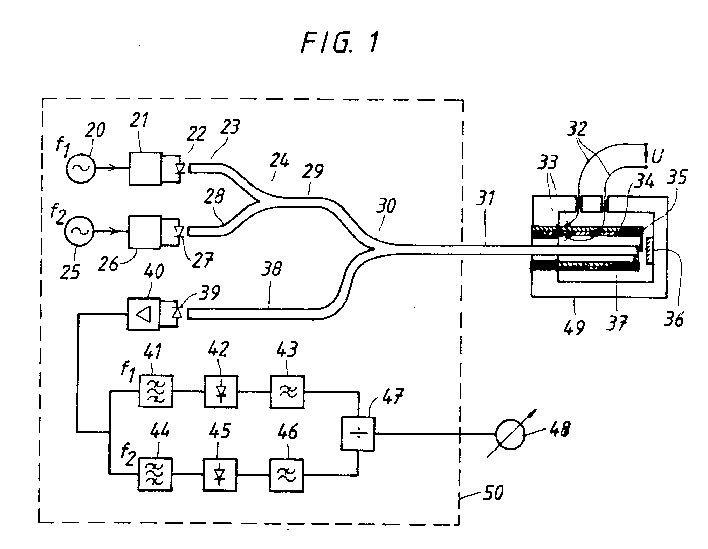

Figur 1 zeigt eine Anordnung mit einem faseroptischen Spannungsmeßgerät, bei dem die Meßspannung U dem Geber 49 zugeführt wird und an die Elektroden 33 eines piezoelektrischen Elements 34 angeschlossen ist. Ein Oszillator 20 moduliert über ein Speiseglied 21 das Licht einer Leuchtdiode 22 mit einer Frequenz $f_1$. Ein anderer Oszillator 25 moduliert über ein Speiseglied 26 das Licht einer anderen Leuchtdiode 27 mit einer Frequenz $f_2$, die von $f_1$ verschieden ist. Die Leuchtdioden 22 und 27 erzeugen Licht mit verschiedenen Wellenlängen ($\lambda_1$ bzw. $\lambda_2$), das über lichtleitende Fasern 23 bzw. 28 und eine Faserverzweigung 24 in einer gemeinsamen lichtleitenden Faser 29 zusammengeführt wird. Diese ist über eine Faserverzweigung 30 an eine lichtleitende Faser 31 angeschlossen, die vor einem Spiegel 36 im Geber 49 endet. Zwischen dem Faserende und dem Spiegel 36 ist ein Schirm 35 als optisches Filter angeordnet. Dieses Filter läßt Signale in einem bestimmten Wellenlängenbereich durch, ist jedoch für Signale mit anderen Wellenlängen undurchlässig. Das Filter 35 ist an einem bimorphen, alternativ multimorphen, piezoelektrischen Element 34 fixiert, an das die Meßspannung U über die Meßleitungen 32 an die Elektroden 33 angeschlossen ist. Aufgrund des piezoelektrischen Effektes verursacht das entstehende elektrische Feld eine Durchbiegung des Elementes 34, wodurch man eine Verschiebung des Schirms 35 vor dem Faserende erhält. Um den Einfluß der Temperatur zu reduzieren, ist die Faser an einem piezoelektrischen Element 37 fixiert, das aus demselben Material besteht wie das Element 34, dem die Meßspannung U zugeführt wird. Das Interferenzfilter hat die Eigenschaft, die Lichtwellenlänge $\lambda_1$, jedoch nicht $\lambda_2$ hindurchzulassen. Das Licht, das vom Spiegel 36 zurückgeworfen wird, läuft durch die Faser 31 zurück, und ein Teil dieses Lichts läuft über die Faserverzweigung 30 in eine Faser 38. Das Licht wird in einer Fotodiode 39 in ein elektrisches Signal umgewandelt, welches in einem Verstärker 40 verstärkt wird. Die im Signal enthaltenen Komponenten mit den Frequenzen $f_1$ und $f_2$ werden durch Bandpaßfilter 41 bzw. 44 ($f_1$, $f_2$), Gleichrichter 42 bzw. 45 und Tiefpaßfilter 43 bzw. 46 voneinander getrennt und demoduliert. Das von dem Tiefpaßfilter 43 kommende Signal wird nicht von der Lage des Schirms beeinflußt, da es so beschaffen ist, daß es Licht mit der Wellenlänge $\lambda_1$ hindurchläßt und somit vom Meßsignal unabhängig ist. Das Ausgangssignal an dem Anzeigegerät 48 besteht aus dem Quotienten aus den Ausgangssignalen der Tiefpaßfilter 46 und 43. Das Ausgangssignal des Tiefpaßfilters 46 ist von der Lage des Schirms 35 abhängig und ist somit mit der Größe des Meßsignals U moduliert. Die Quotientenbildung, die in einem Divisionsglied 47 vorgenommen wird, hat zur Folge, daß das Ausgangssignal gegenüber Parametervariationen in der Übertragung kompensiert ist. Das Meßgerät kann sowohl für Gleich- als auch Wechselspannung verwendet werden. Die einzige Bedingung hierfür besteht darin, daß die Frequenzen $f_1$ und $f_2$ höher liegen als alle im Meßsignal auftretenden interessierenden Frequenzen. Durch die Verwendung von Lichtsignalen unterschiedlicher Frequenzen und durch die Quotientenbildung werden somit die Nachteile kompensiert, die einem nicht kompensierten faseroptischen Meßgerät anhaften.

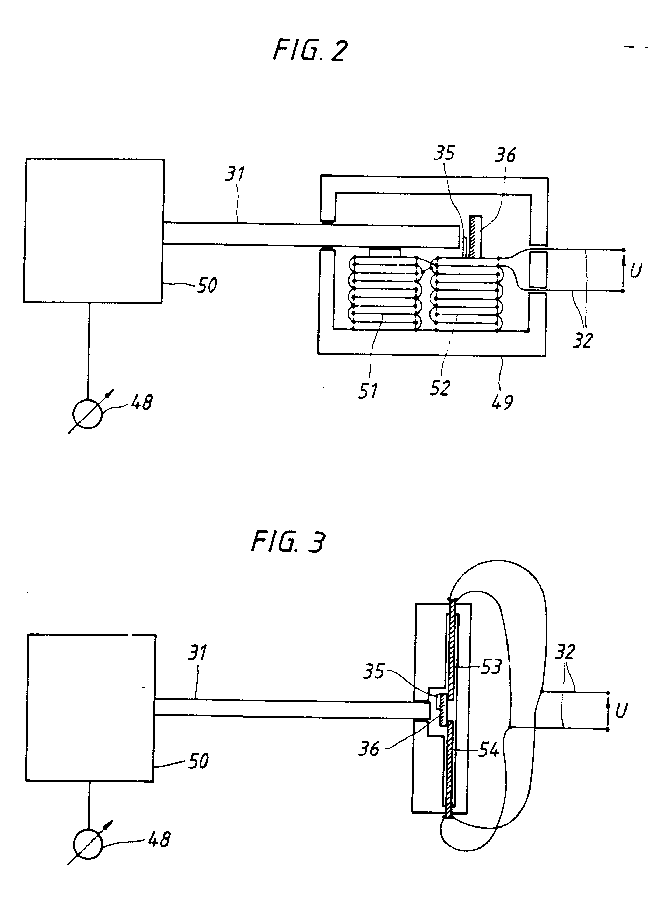

Die Anordnung nach Figur 2 zeigt ein faseroptisches Spannungsmeßgerät, bei dem die Meßspannung U über die Meßleitungen 32 an zwei Stapel 51 und 52 von parallelgeschalteten piezoelektrischen Elementen angeschlossen wird. Die Meßspannung ist mit entgegengesetzter Polarität an die Stapel angeschlossen, was zur Folge hat, daß eine positive Meßspannung die Höhe des einen Stapels vergrößert und die Höhe des anderen Stapels verkleinert und umgekehrt. Durch den Aufbau mit zwei Stapeln wird der Einfluß der Temperatur reduziert, während die Empfindlichkeit gleichzeitig verdoppelt wird. An dem einen Stapel 51 ist das Ende der Faser 31 fixiert, und an dem anderen ist ein Spiegel 36 mit einem als optisches Filter wirkenden Schirm 35 befestigt, der einen Teil des Faserendes abdeckt. Aufgrund der Spannung U bewegt sich der Schirm relativ zur Faser und moduliert das Licht in der Faser 31. Bei dem Auswertungsglied 50 und dem Anzeigegerät 48 handelt es sich um gleichartige Glieder wie in der Anordnung nach Figur 1.

Figur 3 zeigt ein faseroptisches Spannungsmeßgerät, bei dem die elektrooptische Umwandlung mit einem piezoelektrischen Hochpolymer erfolgt. Die Meßspannung U wird über die Meßleitungen 32 mit entgegengesetzter Polarität an zwei Filmstücke 53 und 54 aus piezoelektrischem Hochpolymer angeschlossen. Aufgrund der unterschiedlichen Polarität wird das eine Filmstück gedehnt, während das andere zusammengezogen wird, wenn über die Meßleitungen 32 eine Spannung zugeführt wird. Die Polymerfilmstücke 53 und 54 sind durch einen Spiegel 36 miteinander verbunden, auf dessen Oberfläche ein als optisches Filter wirkender Schirm 35 sitzt. Bei der Dehnung beziehungsweise bei der Zusammenziehung der Filme werden der Spiegel und der Schirm verschoben. Das Licht in der Faser 31 wird von den Bewegungen des Schirms moduliert und beschreibt somit das Meßsignal U. Bei dem Auswertungsglied 50 und dem Anzeigegerät 48 handelt es sich um gleichartige Glieder wie in der Anordnung nach Figur 1.

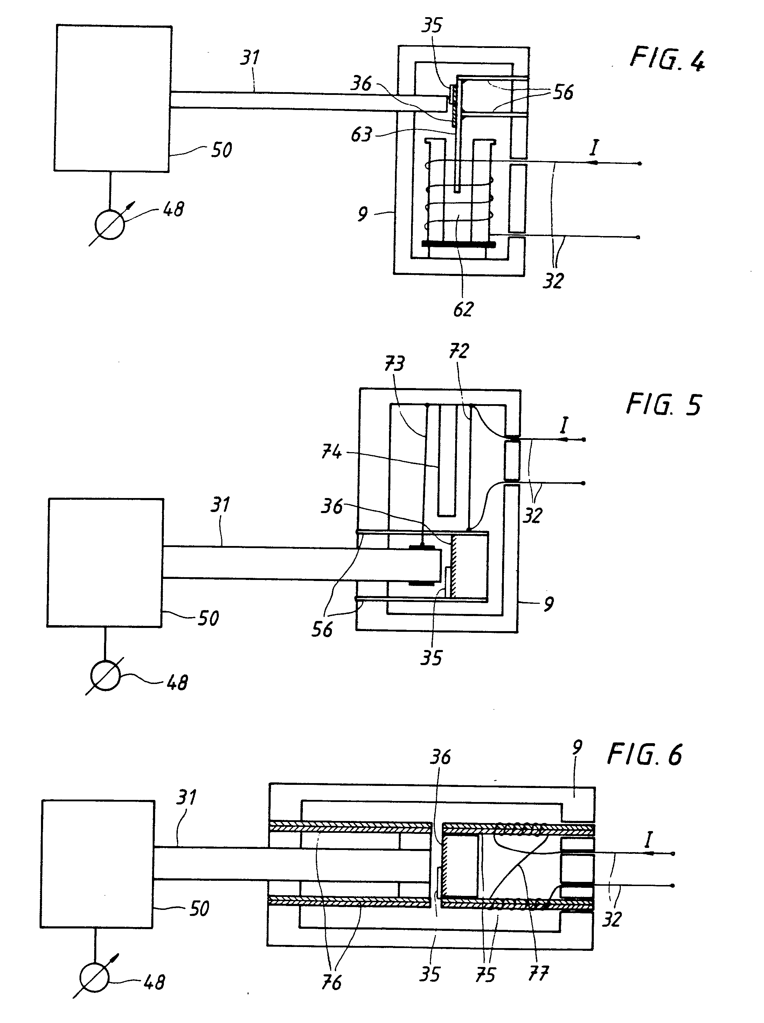

Figur 4 zeigt ein faseroptisches Strommeßgerät, bei welchem der Meßstrom I ein Magnetfeld erzeugt, welches auf ein Stück 63 aus magnetischem Material einwirkt. Der Meßstrom I durchfließt eine Spule 62, in der sich ein Teil des genannten Magnetmaterialstückes 63, z. B. Weicheisen, befindet, welches an Federn 56 befestigt ist und einen Spiegel 36 trägt. Zwischen dem Spiegel 36 und der Endfläche der Faser 31 ist ein als optisches Filter wirkender Schirm 35 angebracht. Der die Spule 62 durchfließende Meßstrom I übt auf das Materialstück 63 eine Anziehungskraft aus, die eine Durchbiegung der Federn 56 bewirkt. Hierdurch wird der Schirm 35 vor der Endfläche der Faser 31 verschoben, wodurch das Licht mit dem Meßstrom I moduliert wird. Bei dem Auswertungsglied 50 und dem Anzeigegerät 48 handelt es sich um gleichartige Glieder wie in der Anordnung nach Figur 1.

Figur 5 zeigt ein Strommeßgerät mit einem optischen Modulator, dessen Wirkung auf der Wärmedehnung eines stromduchflossenen gespannten Drahtes beruht. Der Meßstrom I durchfließt einen Draht 72, dessen eines Ende ortsfest eingespannt ist. Das andere Ende des Drahtes ist an einer Doppelfeder 56 unter Vorspannung befestigt, welche Doppelfeder einen Spiegel 36 trägt, der teilweise von einem mit dem Spiegel verbundenen als optisches Filter wirkenden Schirm 35 bedeckt ist. Der Schirm 35 überdeckt teilweise das Ende der Faser 31. Die Faser 31 ist in einem Draht 73 aufgehängt, der aus demselben Material wie der von Strom durchflossene Draht 72 besteht. Hierdurch werden Temperaturvariationen der Umgebung kompensiert. Der durch den Draht 72 fließende Meßstrom bewirkt eine Verlängerung des Drahtes und damit eine Verschiebung des Spiegels 36 mit dem Schirm 35. Hierdurch erhält man eine Modulation des ankommenden Lichtes in der Faser 31, das zum Auswertungsglied 50 reflektiert wird, bei der es sich ebenso wie bei dem Anzeigegerät 48 um ein gleichartiges Glied handelt wie in der Anordnung nach Figur 1.

Figur 6 zeigt ein faseroptisches Strommeßgerät mit einem optischen Modulator, dessen Wirkung darauf beruht, daß der durch einen Draht fließende Strom Bimetall erhitzt und biegt. Der Meßstrom I durchfließt einen Draht 77, der um zwei Bimetallstreifen 75 gewickelt ist. Die Bimetallstreifen 75 sind an einem Ende fest eingespannt und tragen zwischen ihren anderen Enden einen Spiegel 36. Ein Teil der Spiegelfläche ist mit einem als Interferenzfilter wirkenden Schirm 35 bedeckt, der teilweise die Endfläche der Faser 31 abdeckt. Der Meßstrom I, der durch den Draht 77 fließt, bewirkt eine Erhitzung und damit ein Durchbiegen der Bimetallstreifen 75, wobei sich der Schirm 35 vor der Endfläche der Faser verschiebt und das Licht moduliert. Um die Temperaturvariationen der Umgebung zu kompensieren, ist das Ende der Faser 31 zwischen zwei Bimetallstreifen 76 gleicher Art wie die Bimetallstreifen 75 befestigt. Bei dem Auswertungsglied 50 und dem Anzeigegerät 48 handelt es sich um gleichartige Glieder wie in der Anordnung nach Figur 1.

Die Erfindung kann im Rahmen des offenbarten allgemeinen Erfindungsgedankens in vielfacher Weise variiert werden. Sie ist nicht auf die gezeigten Ausführungsbeispiele beschränkt.

Unter einem »bimorphen« Modulator· oder piezoelektrisches Element im Sinne dieser Anmeldung wird ein piezoelektrischer Kristall mit zwei entgegengesetzten Polarisationsrichtungen verstanden. Ein »multimorphes« piezoelektrisches Element ist ein solches, das beispielsweise aus vier Kristallen besteht, von denen zwei entgegengesetzte Polarisationsrichtungen haben und die beiden anderen untereinander entgegengesetzte Polarisationsrichtungen haben, welche um 180° gegenüber den erstgenannten phasenverschoben sind.

## Patentansprüche

1. Faseroptisches Meßgerät mit mindestens einem Lichtleiter, mit einem Geber (34—37), der einen Wandler zur Umsetzung eines elektrischen Signals in eine mechanische Bewegung enthält, mit einem dem Geber aus einer Lichtquelle (22, 27) über den mindestens einen Lichtleiter (23, 28, 29, 30, 31) zugeleiteten Lichtfluß, der mit der genannten Bewegung analog moduliert wird, und mit einer Einrichtung (36, 31, 38) zur Übertragung des modulierten Lichtes auf einen fotoelektrischen Empfänger (39), dadurch gekennzeichnet, daß das dem Geber zugeführte Licht aus einer Meßkomponente und einer Stabilisierungskomponente (22, 27) besteht, die sowohl unterschiedliche Wellenlängen ($\lambda_1$, $\lambda_2$) haben, und mit unterschiedlichen Frequenzen ($f_1$, $f_2$) moduliert sind, daß dem Geber ein elektrisches Meßsignal (U) zugeführt wird, welches der Geber in eine mechanische Bewegung umwandelt, die auf einen das Faserende des Lichtleiters teilweise abdeckenden Schirm (35) übertragen wird, der für das Licht der Stabilisierungskomponente durchlässig und für das Licht der Meßkomponente nicht oder weniger durchlässig ist, daß vom Faserende aus gesehen hinter dem Schirm (35) ein Spiegel (36) vorhanden ist, der entweder fest angeordnet oder mit dem Schirm (35) verbunden ist und der das Licht in den Lichtleiter (31, 38) reflektiert, und daß das Gerät mit einer Elektronik versehen ist, welche das vom Geber kommende Licht in die Meß- und Stabilisierungskomponente zerlegt und mit Hilfe dieser Komponenten ein Meßsignal bildet, das von der Instabilität der Optoelektronik und der Faseroptik unabhängig ist.

2. Meßgerät nach Anspruch 1, dadurch gekennzeichnet, daß das genannte Faserende und der Spiegel je auf einem gleichartigen Element (51, 52) zur Umwandlung des elektrischen Signals in eine mechanische Bewegung montiert sind und daß eines dieser Elemente (52) an das elektrische Meßsignal angeschlossen ist, während das andere als Temperaturkompensator dient, oder daß beide Elemente (51, 52) mit entgegengesetzter Polarität an das Meßsignal angeschlossen sind, wobei die Empfindlichkeit verdoppelt wird.

3. Meßgerät nach einem der vorhergehenden Ansprüche, dadurch gekennzeichnet, daß der Geber zur Umwandlung des elektrischen Meßsignals in eine mechansiche Bewegung aus piezoelektrischem Material (53, 54) besteht, das als bimorphe Elemente, Hochpolymermembrane oder einfache oder gestapelte Platten ausgebildet ist.

4. Meßgerät nach einem der Ansprüche 1 oder 2, dadurch gekennzeichnet, daß der Geber zur Umwandlung des elektrischen Meßsignals in eine mechanische Bewegung in Federn (56) aufgehängte Elemente enthält, in welchen die Umwandlung entweder durch die Kraftwirkung zwischen zwei stromdurchflossenen Spulen oder einer vom Strom durchflossenen Spule und einem Dauermagneten (57, 59) oder einer stromdurchflossenen Spule und einem weichmagnetischen Material erfolgt.

5. Meßgerät nach einem der Ansprüche 1 oder 2, dadurch gekennzeichnet, daß der Geber zur Umwandlung des elektrischen Meßsignals in eine mechanische Bewegung die elektrostatische Kraftwirkung zwischen elektrisch leitenden Platten oder zwischen elektrisch leitenden Platten und im Feld zwischen den Platten befindlichem ferroelektrischem Material ausnutzt.

6. Meßgerät nach einem der Ansprüche 1 oder 2, dadurch gekennzeichnet, daß der Geber zur Umwandlung des elektrischen Meßsignals in eine mechanische Bewegung die Längenausdehnung eines Drahtes, eines Stabes oder eines Bimetallstückes ausnutzt, der/das von dem vom Meßsignal erzeugten Strom erhitzt wird.

7. Meßgerät nach Anspruch 4, dadurch gekennzeichnet, daß die Federn (56), in welcher die genannten Elemente aufgehängt sind, mindestens zwei parallele Blattfedern sind.

## Claims

1. Fiber optical measuring device with at least one light conductor, with a transmitter (34—37) including a transducer for converting an electrical signal into a mechanical movement, with a light flux conducted from a light source (22, 27) through said at least one light conductor (23, 28, 29, 30, 31) to said transmitter, wherein the light flux is modulated analogically with said movement, and with means (36, 31, 38) for transmitting the modulated light to a photo-electrical receiver (39), characterized in that the light conducted to the transmitter consists of a measuring component and a stabilising component (22, 27) having different wavelengths ($\lambda 1$, $\lambda 2$) and being modulated with different frequencies ($f_1$, $f_2$), that an electrical measuring signal (U) is fed to the transmitter, wherein it is converted into a mechanical movement, which is transmitted to a shield (35) partially covering the end-face of the light conductor and being transparent for the light of the stabilising component and opaque to or less transparent for the light of the measuring component, that behind the shield (35), seen in a direction from the end of the fiber, a mirror (36) is arranged being either rigidly fixed or connected to the shield (35) and reflecting the light into the light conductor (31, 38), and that the measuring device contains an electronic circuit, which resolves the light transmitted from the transmitter into the measuring- and stabilising component and by the aid of these component builds up a measuring signal being independent of the instabilities of the optoelectronics and the fiber optics.

2. Measuring device according to claim 1, characterized in that said fiber end and the mirror are mounted each on an element (51, 52), the elements being of similar kind, for conversion of the electrical signals into the mechanical movement, and that one of these elements (52) is connected to the electrical measuring signal, while the other serves as a temperature compensator, or that both elements (51, 52) are connected to the measuring signal with different polarities, whereby the sensitivity will be doubled.

3. Measuring device according to any of the preceding claims, characterized in that the transmitter for conversion of the electric measuring signal into a mechanical movement consists of piezoelectrical material (53, 54) designed as bimorph elements, high polymer membranes, or single, alternatively piled plates.

4. Measuring device according to claim 1 or 2, characterized in that the transmitter for conversion of the electrical measuring signal into a mechanical movement contains elements suspended in springs (56), in which the conversion is obtained either by the force developed between two current conducting coils, or by one current conducting coil and one permanent magnet (57, 59), or by one current conducting coil and a low-retentivity magnetic material.

5. Measuring device according to any of claim 1 or 2, characterized in that the transmitter for conversion of the electrical measuring signal into a mechanical movement makes use of the electrostatical force developed between electrically conducting plates or between electrically conducting plates and ferroelectrical material in the field between these plates.

6. Measuring device according to claim 1 or 2, characterized in that the transmitter for conversion of the electrical measuring signal into a mechanical movement makes use of the mechanical elongation of a wire, a rod or a piece of bimetal, which elongation is obtained by heating said object with a current generated by the measuring signal.

7. Measuring device according to claim 4, characterized in that the springs (65), in which said elements are suspended, consist of at least two parallel plate springs.

## Revendications

1. Appareil de mesure à fibres optiques comprenant au moins un guide de lumière, un générateur (34 à 37) comportant un transducteur pour transformer un signal électrique en un déplacement mécanique, un flux lumineux, qui est envoyé d'une source lumineuse (22, 27) au générateur par le au moins un guide de lumière (23, 28, 29, 30, 31) et qui est modulé analogiquement par le déplacement mentionné, et un dispositif (36, 31, 38) de transmission de la lumière modulée à un récepteur photoélectrique (39), caractérisé en ce que la lumière envoyée au générateur est constituée d'une composante de mesure et d'une composante de stabilisation (22, 27), qui ont des longueurs d'onde ($\lambda_1$, $\lambda_2$) différentes et qui sont modulées à des fréquences ($f_1$, $f_2$) différentes, en ce qu'au générateur est envoyé un signal électrique de mesure (U), que le générateur transforme en un déplacement mécanique transmis à un écran (35) recouvrant partiellement l'extrémité de la fibre du guide de lumière, transparent à la lumière de la composante de stabilisation et opaque ou moins transparent à la lumière de la composante de mesure, en ce qu'il y a en arrière, considéré depuis l'extrémité de la fibre, de l'écran (35) un miroir (36), qui est fixé ou qui est relié à l'écran (35) et qui réfléchit la lumière dans les guides de lumière (31, 38) et en ce que l'appareil est muni d'une électronique qui décompose la lumière venant du générateur en les composantes de mesure et de stabilisation et qui forme à l'aide de ces composantes un signal de mesure qui est indépendant de l'instabilité de l'optoélectronique et de l'optique à fibres.

2. Appareil de mesure suivant la revendication 1, caractérisé en ce que l'extrémité de fibre mentionnée et le miroir sont montés respectivement sur un élément (51, 52) de même type de conversion du signal électrique en un déplacement mécanique, et en ce que le signal électrique de mesure est appliqué à l'un de ces éléments (52), tandis que l'autre sert de compensateur de température, ou en ce que le signal de mesure est appliqué à ces deux éléments (51, 52) ayant une polarité opposée, ce qui multiplie par deux la sensibilité.

3. Appareil suivant l'une des revendications précédentes, caractérisé en ce que le générateur de conversion du signal électrique de mesure en un déplacement mécanique est constitué en un matériau piézoélectrique (53, 54) qui a la forme d'éléments bimorphes, de membranes en haut polymère, ou de plaques simples ou empilées.

4. Appareil de mesure suivant l'une des revendications 1 ou 2, caractérisé en ce que le générateur de conversion du signal électrique de mesure en un déplacement mécanique contient des éléments suspendus dans des ressorts (56), éléments dans lesquels la conversion s'effectue soit par l'effet dynamique entre deux bobines dans lequel passe du courant électrique, ou entre une bobine dans laquelle passe du courant électrique et un aimant permanent (57, 59), ou une bobine dans laquelle passe du courant électrique et un matériau magnétique doux.

5. Appareil de mesure suivant l'une des revendications 1 ou 2, caractérisé en ce que le générateur de conversion du signal électrique de mesure en un déplacement mécanique utilise l'effet de la force électrostatique entre des plaques conductrices d'électricité, ou entre des plaques conductrices d'électricité et un matériau ferro-électrique se trouvant dans le champ entre les plaques.

6. Appareil de mesure suivant l'une des revendications 1 ou 2, caractérisé en ce que le convertisseur de conversion du signal électrique de mesure en un déplacement mécanique utilise la dilatation en longueur d'un fil, d'une tige ou d'un bilame, qui est réchauffé par le courant électrique produit par le signal de mesure.

7. Appareil de mesure suivant la revendication 4, caractérisé en ce que les ressorts (56), dans lesquels les éléments mentionnés sont suspendus, sont au moins deux ressorts parallèles à lames.

# FIG. 1

## FIG. 2

## FIG. 3

FIG. 4

FIG. 5

FIG. 6